# EUROPEAN PATENT SPECIFICATION

(11) **EP 3 349 247 B1**
(45) Date of publication and mention of the grant of the patent: **23.12.2020**
(21) Application number: 17151472.2
(22) Date of filing: 13.01.2017
(51) Int. Cl.: H01L 23/538, H01L 23/544

(54) **PATTERNED COVER LAYER ON BASE STRUCTURE DEFINING CAVITY AND ALIGNMENT MARKER**
STRUKTURIERTE DECKSCHICHT AUF BASISSTRUKTUR ZUR DEFINITION EINES HOHLRAUMS UND AUSRICHTUNGSMARKIERUNG
COUCHE DE RECOUVREMENT À MOTIFS SUR UNE CAVITÉ DÉLIMITANT UNE STRUCTURE DE BASE ET MARQUEUR D'ALIGNEMENT

(43) Date of publication of application: 18.07.2018
(73) Proprietor: AT & S Austria Technologie & Systemtechnik Aktiengesellschaft, 8700 Leoben (AT)
(72) Inventor: Schrittwieser, Wolfgang, 8605 Kapfenberg (AT); Christandl, Robert, 8700 Leoben (AT); Feichtner, Andreas, 8792 St. Peter-Freienstein (AT); Pilz, Heinz, 8793 Trofaiach (AT); Moser, Peter, 8700 Leoben (AT)
(74) Representative: Dilg, Haeusler, Schindelmann Patentanwaltsgesellschaft mbH

(56) References cited:
- US-A1- 2007 095 471
- US-A1- 2013 256 007
- US-A1- 2014 299 367
- US-B1- 6 515 356

## Description

The invention relates to methods of manufacturing a package, a semifinished product and a panel.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Moreover, proper alignment of a component embedded in a component carrier is an issue. Other issues in terms of registration accuracy may occur as well in component carrier manufacture.

US2013/0256007 discloses a wiring board with a built-in electronic component and its manufacturing method. US2014/0299367 discloses a component-embedded substrate manufacturing method for embedding electrical or electronic components in a substrate and a component-embedded substrate manufactured using the same.

It is an object of the invention to enable manufacture of a package with high spatial accuracy.

In order to achieve the object defined above, methods of manufacturing a package, a semifinished product and a panel according to the independent claims are provided.

According to an exemplary embodiment of the invention, a method of manufacturing a package (in particular a component carrier) is provided, wherein the method comprises providing a patterned cover layer on a front side of a base structure (in particular a core) to thereby define a position of a cavity to be formed in the base structure and to define a position of at least one alignment marker in a common procedure (in particular a cavity position defining marker and an alignment marker may be formed by a common simultaneous procedure), forming the cavity at the defined position, and removing material of the base structure from a back side to thereby expose the at least one alignment marker.

According to another exemplary embodiment of the invention, a method of manufacturing a package is provided, wherein the method comprises patterning a cover layer on a base structure (in particular a core) to thereby expose the base structure selectively at a circumferential opening in the cover layer, and forming a cavity by removing (in particular by cutting out) a section of the base structure within (i.e. delimited by) the circumferential opening.

According to still another exemplary embodiment of the invention, a panel for manufacturing a plurality of packages is provided, wherein the panel comprises a base structure (in particular a core) having a cavity (or multiple cavities), a component (or multiple components) embedded in the cavity (or the multiple cavities), a patterned cover layer on a front side of the base structure and having at least one alignment marker (in particular a plurality of alignment markers) in form of an opening extending through the cover layer, and a further opening (or multiple further openings) extending through the base structure from a back side and exposing the at least one alignment marker (in particular the plurality of alignment markers).

According to yet another exemplary embodiment, a semifinished product is provided which comprises a base structure (in particular a core), and a cover layer on the base structure, wherein the cover layer is patterned so as to have a circumferential opening exposing the base structure for defining a position of a cavity to be formed and at least one opening in the cover layer as at least one alignment marker.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

According to an exemplary embodiment of the invention, a method of manufacturing a package is provided which allows to obtain a very high spatial registration accuracy, for instance in terms of embedding a component and/or formation of one or more contacts for back side contacting a component. This is accomplished by carrying out the manufacturing procedure using a base structure with a cover layer thereon and patterning the latter to thereby define at the same time a position of a cavity in which an electronic component is to be embedded later, and for defining one or more alignment markers. Due to the simultaneous formation of cavity defining cover layer structure(s) and alignment marker(s), they have a well-defined mutual spatial relationship, so that knowledge of the position of the alignment marker(s) allows to derive determination of cavity position with high precision. After having formed the cavity on the basis of the described definition and after having embedded the component in the cavity, the component may be contacted from a back side by removing base structure material from the back side to thereby expose the alignment markers. On the basis of this knowledge of the alignment marker position, also the exact position of the component in the cavity (defined at the same time with the formation of the alignment markers) is known. Thus, one or more buried pads of the component may be precisely met by a drilling procedure, since this position can be precisely predicted based on the knowledge of the position of the one or more now exposed alignment markers.

According to another aspect of an exemplary embodiment of the invention, the combined and simultaneous definition of the cavity by the formation of a circumferential opening through the cover layer and the formation of the one or more alignment holes may be the followed by a formation of the cavity which removes material (preferably by laser processing) for instance by simply cutting through the base structure material which is exposed around the circumferential opening. The cover layer - which can be preferably still present as a metallic island within the circumferential opening during the removal of the base structure material - may prevent an undesired burning of the base structure material during cavity formation which may conventionally cause the formation of undesired carbon structures delimiting the cavity. Such parasitic electrically conductive carbon structures, which may conventionally be a source of undesired and undefined paths of electric conductivity within a package with embedded component, may be strongly suppressed or even eliminated by exemplary embodiments. The definition of the formed cavity may also be rendered much more precise by keeping the material of the cover layer on the base structure within the circumferential opening. Thus, a more precisely defined position of an embedded component can be achieved by an exemplary embodiment.

In the following, further exemplary embodiments of the methods of manufacturing a package, the semifinished product and the panel will be explained.

In an embodiment, a plurality of alignment markers are defined, formed and exposed. For instance, such multiple alignment markers are dots. It is however also possible to use one or more alignment markers with a more complex geometric shape, for instance the shape of a cross. When having such a geometric shape, a single alignment marker may be sufficient.

In an embodiment, the method comprises embedding a component in the cavity. A package manufactured like this may be denoted as an embedded component package. The mentioned component may for instance by an electronic chip which provides an electronic function in an interior of the package and which may require one or more external electric contacts. For high spatial accuracy, a precise alignment between alignment marker(s) and cavity is of utmost importance.

In an embodiment, the method comprises forming at least one contact to the embedded component from the back side and at a position derived from the exposed at least one alignment marker. Such a contact may be an electric contact (such as an electric copper-filled via) for carrying an electric signal and/or a thermal contact (such as a thermal copper-filled via) for removing thermal energy from the component. Thanks to the precise alignment between the cavity defining cover layer pattern and the simultaneously formed alignment marker(s), a high registration accuracy and consequently a high reliability of the package may be obtained.

In an embodiment, the cover layer is a metal layer, in particular a copper layer. A metal layer, in particular a copper layer, can be easily laminated on a base structure with package procedures, for instance PCB procedures. It may be easily patterned and it may remain on a surface of a base structure (such as a core, for instance made of FR4) during a laser cutting procedure of removing material from the base structure. The remaining copper layer may serve for a more homogeneous heat distribution and may prevent FR4 material of the base structure from burning during the cutting procedure, which results in more precisely defined sidewalls without artefacts thereon due to burning.

In an embodiment, the cover layer is patterned by a lithography and etching procedure. This is a simple and precise way of defining the one or more alignment markers and the structure(s) defining the position of the cavity at the same time.

In an embodiment, patterning the cover layer comprises forming a circumferential opening defining the position of the cavity. Such an annular opening or clearance (which may for instance be rectangular, circular, etc.) may expose surface portions of the base structure which can be removed easily in the presence of a cutting laser. Thus, the more robust and temperature-stable material of the cover layer may remain there during the cavity formation procedure, whereas the base structure material may be removed selectively at a portion which allows to cut out a piece of the base structure layer without burning it excessively. This results in a cavity comprising base structure with better spatial definition and properties allowing to obtain a more reliable package.

In an embodiment, the cavity is formed by cutting out a section of the base structure within the exposed circumferential opening. Highly preferably, this cutting procedure is carried out with a laser. The energy of the laser will remove the material of the base structure selectively around the circumferential opening, because the heat transfer from the laser to the base structure material is significantly better at this circumferential opening than through the thermally stable and thermally conductive cover layer. However, alternatively, the cutting procedure may also be accomplished mechanically (for instance by mechanically drilling) or chemically (for instance by etching).

In an embodiment, the cavity is defined by laser cutting the base structure at the defined position. For this laser cutting procedure, it is for instance possible to implement a CO₂ laser. Other appropriate types of lasers may be used as well. Since the position of the cavity has already been defined by the patterning of the cover layer before initiating the laser cutting procedure, the laser can be positioned spatially relatively unspecific above the cover layer. In other words, a slight misalignment of the laser will not have a negative impact on the accuracy of the position of the cavity formed by the laser cutting procedure.

In an embodiment, the method further comprises temporarily attaching a temporary carrier (i.e. attached only during manufacture, wherein the temporary carrier is removed before completing formation of a readily manufactured package) at the back side of the base structure to close the cavity. Such a temporary carrier may hence be used for holding the component during the embedding procedure until the manufactured structure is stable enough to hold even without the temporary carrier. The latter condition is usually fulfilled after a lamination process by which further material (such as prepreg) is laminated on the structure and is cured.

In an embodiment, the temporary carrier comprises a rigid plate. When a rigid plate is used as temporary carrier, it further simplifies handling. A rigid plate provides a remarkably high degree of stability. Moreover, such a rigid carrier prevents problems with warpage and the like during manufacturing the packages. Alternatively, it is possible to use a sticky tape as temporary carrier.

In an embodiment, the temporary carrier (for instance embodied with a rigid plate or a tape) has a sticky or adhesive surface facing the base structure and the component. Advantageously, the temporary carrier may be adhesive, so as to adhere both to the base structure and the component during embedded the component in the cavity.

In an embodiment, the method further comprises connecting the front side of the base structure, the cover layer and the component embedded in the cavity with at least one electrically insulating layer structure and/or at least one electrically conductive layer structure, in particular by laminating. By such a lamination procedure, the resulting pre-form of the package obtains a sufficient stability that the temporary carrier is no longer is necessary. During the lamination, it is for instance possible that a curable dielectric material (in particular resin) is cured, becomes hard and then provides a sufficient stability so as to stay in shape even after removal of the temporary carrier.

In particular, the method further comprises removing the above mentioned temporary carrier from the component and the base structure after the above mentioned connecting. Thus, the temporary carrier can be removed from the rest of the package under manufacture after the lamination procedure.

In an embodiment, the method further comprises connecting at least one further electrically insulating layer structure and/or at least one further electrically conductive layer structure on the back side of the base structure and the component, in particular by laminating. Following the above-described lamination process and the subsequent removal of the temporary carrier, the thereby exposed side or surface of the obtained package under manufacture at which previously the temporary carrier had been applied can be covered with further laminable material. By taking this measure, a vertically symmetric structure may be obtained which is advantageous in terms of suppression of warpage and delamination. Moreover, this has the consequence that the component is also embedded within the laminated material from the back side. Subsequently contacting the now embedded component can then be accomplished by first exposing the alignment structure(s) and by subsequently drilling (for instance by laser drilling) one or more holes in the further laminated structure. The position of this one or more holes can be determined precisely based on the precision of the one or more alignment markers.

In an embodiment, exposing the at least one alignment marker comprises removing material of the at least one further electrically insulating layer structure and/or at least one further electrically conductive layer structure. The procedure of removing material from the back side in order to find the position of the one or more alignment markers may be accomplished preferably by laser drilling. However, it is alternatively also possible to expose the alignment markers from the back side by mechanical drilling or by an etching procedure.

In an embodiment, forming the at least one contact comprises forming at least one access hole through the at least one further electrically insulating layer structure and/or at least one further electrically conductive layer structure for exposing the embedded component. In particular, it may be possible to thereby expose at least one pad of the embedded component, if there is such at least one pad. Subsequently, the at least one access hole may be filled with electrically conductive material, for instance by plating (such as electroless plating, electroplating, chemically plating, etc.). Again, access hole formation may be accomplished by laser drilling, mechanical drilling or by an etching procedure. Laser drilling is however preferred. After laser drilling, a plating procedure may fill the formed access holes partly or completely with electrically conductive material, in particular copper.

In an embodiment, material of the cover layer within the circumferential opening remains on the base structure during forming the cavity. When the interior of the cover layer within the circumferential opening remains on the cover layer during the formation of the cavity, its thermally conductive properties may help to distribute the generated heat over the base structure so that undesired burning of the base structure can be prevented or at least strongly suppressed. The result of such a burning process can be an electrically conductive carbon structure which may disturb the electric functionality of the package. Highly advantageously and surprisingly, keeping the central island of the cover layer (separated from the rest of the cover layer by the circumferential opening) on the base structure during the laser cutting may significantly improve the quality of the obtained cavity and the accuracy of the embedded component, as well as the reliability of the manufactured package.

In an embodiment, forming the cavity is carried out by laser cutting. Advantageously, such a procedure is not very sensitive to the exact position of the laser, because the circumferential opening defines the position of the formed cavity. Thus, a simple manufacturing procedure which is not prone to failure or inaccuracy in case of a slight misalignment of the laser is obtained.

In an embodiment, patterning the cover layer comprises forming at least one alignment marker as at least one further opening in the cover layer simultaneously with the forming of the circumferential opening. Simultaneously defining the circumferential opening and the alignment marker is highly advantageously to obtain a very high accuracy.

In an embodiment, after forming the cavity, sidewalls of the cavity may be conditioned (in particular by desmearing) for subsequently embedding a component therein. Conditioning the sidewalls (for instance by removing electrically conductive carbon structures which may be generated during the procedure of cutting out a section of the base structure for cavity formation, plasma activating a side wall surface, etc.) may further increase the electrical and/or mechanical reliability of the manufactured package.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the package. For example, a magnetic element can be used as a component. Such a magnetic element may be a permanent magnetic element (such as a ferromagnetic element, an antiferromagnetic element or a ferrimagnetic element, for instance a ferrite base structure) or may be a paramagnetic element. However, the component may also be a further package, for example in a board-in-board configuration. The component may be surface mounted on the package and/or may be embedded in an interior thereof.

In an embodiment, the package comprises a stack of at least one electrically insulating layer structure and at least one electrically conductive layer structure. For example, the package may be a laminate of the mentioned electrically insulating layer structure(s) and electrically conductive layer structure(s), in particular formed by applying mechanical pressure, if desired supported by thermal energy. The mentioned stack may provide a plate-shaped package capable of providing a large mounting surface for further components and being nevertheless very thin and compact. The term "layer structure" may particularly denote a continuous layer, a patterned layer or a plurality of non-consecutive islands within a common plane.

In an embodiment, the package is shaped as a plate. This contributes to the compact design, wherein the package nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the package is configured as a component carrier. Such a component carrier may be configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by filling them with electrically conductive material (in particular copper), thereby forming vias. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the package as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the package is a laminate-type package. In such an embodiment, the package is a compound of multiple layer structures which are stacked and connected together by applying a pressing force, if desired accompanied by heat.

The aspects defined above and further aspects of the invention are apparent from the examples of embodiment to be described hereinafter and are explained with reference to these examples of embodiment.
Figure 1 to Figure 9 illustrate cross-sectional views of structures obtained during carrying out a method of manufacturing a package and embedding a component therein according to an exemplary embodiment of the invention.
Figure 2A illustrates a plan view of Figure 2.
Figure 10 illustrates a panel and a section thereof comprising multiple packages according to yet another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, an embedded component package with high accuracy is provided. More specifically, an exemplary embodiment of the invention provides a package or module with embedded electronic component which is configured so that the entire registration chain is rendered highly efficient and therefore the manufacturing tolerances may be kept very small. By taking this measure, it is possible to obtain a high packing density, thereby allowing to obtain also a high or extensive functionality of the embedded component package.

An advantage obtainable by exemplary embodiments of the invention is a high quality registration between cavity and component. Furthermore, a proper quality of a cutting edge defining the cavity can be obtained by a very good heat removal capability during a laser cutting procedure for cutting out base structure material for cavity formation. Such a procedure can be make use of a conformal mask process. This advantage can even be obtained when using materials with a relatively low melting point, for instance polyimide. Also, exemplary embodiments make it possible to carry out a laser cutting procedure in a particularly fast way due to the possibility of using of a high laser energy or pulse energy (which can be particularly obtained when a portion of the cover layer remains on the base structure after having formed the circumferential opening and during the laser impact). A high flexibility may be obtained in terms of shape and design of the cavities. Moreover, a proper mechanical stability of the base structure may be obtained due to the provision of the cover layer which can be realized as a surface copper layer. Moreover, there is no danger of contaminating a sticky carrier plate or any other temporary carrier due to high quality cutting edges which may be achieved by exemplary embodiments of the invention. Furthermore, the alignment of the laser process for contacting an embedded component can be based on the alignment markers (for instance when implementing skiving or X-ray). This may allow to obtain a high precision, thereby making it possible to obtain small tolerances upon contacting the embedded component.

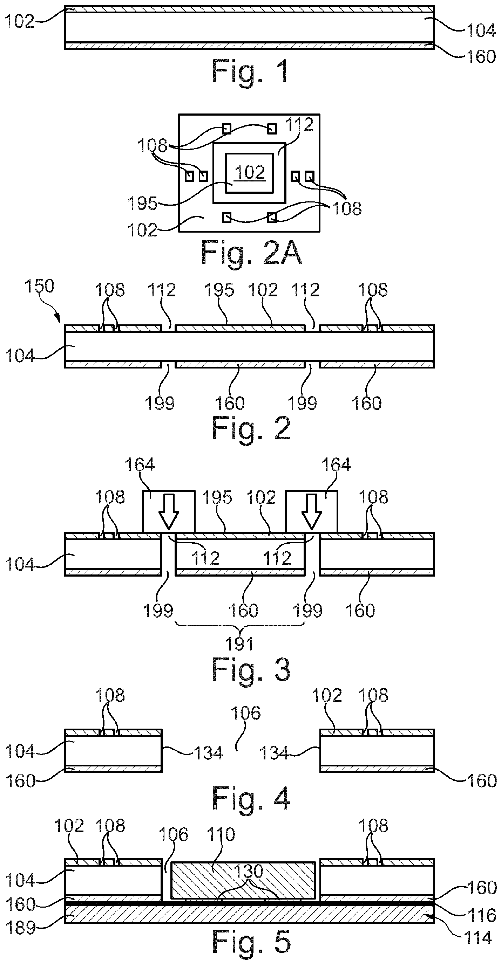

Figure 1 to Figure 9 illustrate cross-sectional views of structures obtained during carrying out a method of manufacturing a package 100 and embedding a component 110 therein according to an exemplary embodiment of the invention.

Referring to **Figure 1****,** a cover layer 102, here embodied as a copper foil, is attached to a first main surface of a base structure 104, here embodied as a core which may for instance be made of FR4 material. A further cover layer 160, here embodied as a further copper foil, is attached on an opposing second main surface of the base structure 104. In Figure 1, the base structure 104 of fully cured material is hence covered on both of its opposing main surfaces with a respective copper foil, see cover layer 102 and further cover layer 160.

Referring to **Figure 2****,** both the cover layer 102 and the further cover layer 160 are patterned. Patterning the cover layer 102 comprises forming a circumferential opening 112 and alignment markers 108 as further openings in the cover layer 102. By patterning the cover layer 102 on the base structure 104, surface portions of the base structure 104 are selectively exposed. By patterning the cover layer 102 on a front side of the base structure 104 a position of a cavity 106 (see Figure 4)) to be formed in the following is defined. Simultaneously with the formation of the circumferential opening 112, the alignment markers 108 are formed in a common procedure. In the described embodiment, the cover layer 102 is patterned by a lithography and etching procedure. Also the further cover layer 160 is patterned by a lithography and etching procedure. Consequently, a further circumferential opening 199 is formed which corresponds to the circumferential opening 112 in the cover layer 102. The further circumferential opening 199 vertically flushes with the circumferential opening 112. Together, the further circumferential opening 199 and the circumferential opening 112 define a piece of material of the base structure 104 which is cut out later for forming cavity 106. No alignment holes 108 need to be formed in the further cover layer 160.

The structure shown in Figure 2 constitutes a semifinished product 150 according to an exemplary embodiment of the invention. This semifinished product 150 is composed of the base structure 104, the patterned cover layer 102 on the base structure 104, and the patterned further cover layer 160 on the base structure 104.

As can be taken from Figure 2, the definition of the cavity 106 under formation is performed by forming cooperating circumferential openings 112, 199 in the cover layers 102, 160. In addition to that, alignment markers 108 (which may be for instance be dots, circles, crosses, longitudinal structures, etc.) are formed as further openings in the cover layer 102 only. It is advantageous that the formation of the alignment markers 108 and of the circumferential opening 112 in the upper cover layer 102 is carried out by the same lithography and etching procedure. This allows to keep the registration accuracy high.

**Figure 2A** illustrates a plan view of the semifinished product 150 of Figure 2 and in particular shows the array of here dot-like alignment markers 108 and the here rectangular (alternatively circular, oval or polygonal) circumferential opening 112. The circumferential opening 112 delimits an isolated island 195 of the cover layer 102.

Referring to **Figure 3****,** the cavity 106 (see Figure 4) is formed by cutting out a section 191 of the base structure 104 within the exposed circumferential openings 112, 199. This formation of the cavity 106 is defined by laser cutting the base structure 104 at the defined position, i.e. along the circumferential vertical cutting line defined between the circumferential openings 112, 199. As can be taken from Figure 3, a laser 164 is used for this purpose (in the shown embodiment a CO₂ laser). As can be taken from Figure 3 as well, material of the cover layer 102 within the circumferential opening 112, i.e. the island 195, remains on the base structure 104 during forming the cavity 106 by laser cutting. The laser 164 applies a spatially highly concentrated beam of thermal energy to the semifinished product 150, which beam is directed to the position of the circumferential openings 112, 199 so that the laser energy cuts away the exposed material of the base structure 104 between these two cover layers 102, 160 with circumferential openings 112, 199, thereby isolating the section 191 with regard to the rest of the semifinished product 195. Advantageously, the fact that the continuous island 195 of the cover layer 102 within the circumferential opening 112 remains part of the semifinished product 150 during the laser procedure allows to achieve a homogeneous thermal impact of the laser energy. This prevents undesired burning of fully cured resin material of the base structure 104. The mentioned advantage may be obtained thanks to the high thermal conductivity and the thermal energy distributing capability of the copper material of the island 195 of the cover layer 102. This prevents the formation of electrically conductive carbon as a result of an uncontrolled burning process of the material of the base structure 104. Such electrically conductive carbon might define undesired electrically conductive paths within a readily manufactured package 100 which might deteriorate or even damage the electric functionality of the package 100.

**Figure 4** shows the result of the described procedure, i.e. shows the cavity 106 formed at the defined position after removal of the separated section 191. After having formed the cavity 106, sidewalls 134 of the cavity 106 may be conditioned by desmearing and/or plasma activation for preparing (in particular cleaning and/or adhesion promotion) the structure for subsequently embedding a component 110 therein. Figure 4 shows the result of the laser cutting procedure for forming the cavity 106 as defined due to the patterning procedure of Figure 2. The sidewalls 134 delimiting the manufactured cavity 106 are of high quality and substantially free of electrically conductive carbon due to the homogeneous energy distribution of the laser energy during the laser cutting procedure. If, under undesired circumstances, some conductive carbon material or other contaminants should remain on the sidewalls 134 after the laser cutting procedure, these sidewalls 134 may be cleaned, conditioned, surface-activated, etc. in order to further improve the quality and reliability of the package 100 under manufacture.

Referring to **Figure 5****,** a temporary carrier 114 is first attached at the back side of the base structure 104 before mounting the component 110 in the cavity 106 and on the temporary carrier 114. The temporary carrier 114 comprises a rigid plate 189 (for instance made of FR4 material) and has a sticky surface 116 (which may be an adhesive layer) on the rigid plate 189 facing and adhering the base structure 104 and the component 110. After attachment of the temporary carrier 114 to a lower main surface of the structure shown in Figure 4, component 110 is mounted in the cavity 106 and on the sticky surface 116 of the temporary carrier 114. In the shown embodiment, the component 110 is embodied as an electronic component, more precisely as a semiconductor chip with pads 130, for instance made of copper. In the shown embodiment, the component 110 has the pads 130 on its lower main surface. It may alternatively also have pads 130 on both opposing main surfaces thereof.

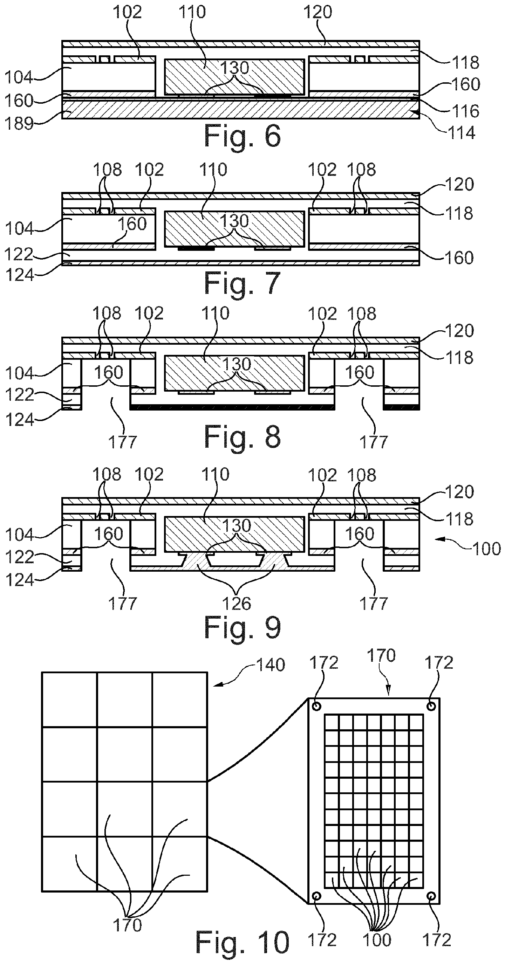

Referring to **Figure 6****,** the front side of the base structure 104 being partially covered by the patterned cover layer 102 as well as the component 110 embedded in the cavity 106 are laminated together with an electrically insulating layer structure 118 and an electrically conductive layer structure 120. The electrically conductive layer structure 120 may be a copper foil. The electrically insulating layer structure 118 may comprise epoxy resin reinforced with glass fibers, i.e. may be made of prepreg material. The structure shown in Figure 6 is therefore obtained by laminating the further at least one electrically insulating layer structure 118 and the further electrically conductive layer structure 120 on an upper side of the structure shown in Figure 5. During this lamination procedure, the material of the further electrically insulating layer structure 118 may flow in gaps between the component 110 and the sidewalls 134 of the base structure 104 delimiting the cavity 106. These gaps may hence be filled with resin material or the like which is cured during the lamination procedure. As an alternative to filling of the gap between the component 110 and the base structure 104 with resin due to the lamination, it is also possible to fill the gap by adhesive material which can be inserted into the cavity 106 for instance before mounting the component 110 therein. The lamination cures the structure of Figure 6 which thereby becomes mechanically robust. Thereafter, the temporary carrier 114 is no longer needed for mechanically supporting or stabilizing the constituents of the structure shown in Figure 6 and is removed from the rest of the structure.

Hence, in order to obtain the structure shown in **Figure 7****,** the temporary carrier 114 is removed from the component 110 and the base structure 104 after the connecting. Thereafter, a further electrically insulating layer structure 122 and a further electrically conductive layer structure 124 are connected on the back side of the base structure 104 and the component 110 by laminating. The further electrically conductive layer structure 124 may be a copper foil. The further electrically insulating layer structure 122 may comprise epoxy resin reinforced with glass fibers, i.e. may be made of prepreg material. It is advantageous that, in the vertical direction according to Figure 7, a symmetric distribution of the various material compositions is obtained in order to suppress warpage, delamination, etc. of the readily manufactured package 100 during its operation.

Referring to **Figure 8****,** the alignment markers 108 are exposed by removing material of the further electrically insulating layer structure 122 and the further electrically conductive layer structure 124. Thereby, openings 177 are formed in the base structure 104 which constitute blind holes in the entire layer structure shown in Figure 8. Figure 8 shows the structure according to Figure 7 after having drilled laser holes from a bottom side of the package 100 under manufacture so as to expose the alignment holes 108 from the back side. Therefore, a later back side contacting procedure (see Figure 9) can be carried out based on a precise knowledge of the positions of the alignment markers 108. Consequently, it will then also be precisely known where the embedded component 110 is located, since cavity 106 definition and alignment marker 108 formation has been done in a common procedure and thus without mutual misalignment according to Figure 2. The mentioned information can hence be derived from that fact that formation of the alignment markers 108 and definition of the position of the cavity 106 (via the circumferential opening 112) have been carried out by a single common patterning procedure of the cover layer 102.

Referring to **Figure 9****,** electrically conductive electric contacts 126 (here embodied as copper filled laser vias) to the pads 130 of the embedded component 110 from the back side and at a position derived from the exposed alignment markers 108 are formed. This formation of the contacts 126 comprises forming access holes through the further electrically insulating layer structure 122 and the further electrically conductive layer structure 124. Thereby, the pads 130 of the embedded component 110 are exposed with high registration accuracy. Subsequently, the access holes are filled with electrically conductive material, such as copper, for instance by plating.

With the known information concerning the position of the component 110 in the cavity 106, and also of its pads 130, it is thus possible, as shown in Figure 9, to laser drill access holes which can be subsequently filled with copper to thereby electrically connect the buried pads 130 with an external surface of the package 100. Thereby, a laminate-type package 100 shaped as a plate and being configured as a printed circuit board (PCB) is obtained.

**Figure 10** illustrates a panel 140 and an enlarged view of a section 170 thereof comprising multiple packages 100 manufactured according to Figure 1 to Figure 9. The shown panel 140 forms a preform for manufacturing the plurality of packages 100 prior to singularization. Each of the sections 170 comprises an arrangement of multiple packages 100. Overall alignment holes 172 are shown in Figure 10 as well. Thus, the packages 100 manufactured according to Figure 1 to Figure 9 can be manufactured in a batch procedure, i.e. on panel level.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of manufacturing a package (100), wherein the method comprises:
providing a patterned cover layer (102) on a front side of a base structure (104) to thereby define a position of a cavity (106) to be formed in the base structure (104) and of at least one alignment marker (108) in a common procedure;
forming the cavity (106) at the defined position;
removing material of the base structure (104) from a back side to thereby expose the at least one alignment marker (108).

2. The method according to claim 1, wherein the method comprises embedding a component (110) in the cavity (106) so that an embedded component package (100) is formed, wherein in particular the method comprises forming at least one contact (126) to the embedded component (110) from the back side and at a position derived from the exposed at least one alignment marker (108).

3. The method according to claim 1 or 2, comprising at least one of the following features:
wherein the cover layer (102) is a metal layer, in particular a copper layer;
wherein the cover layer (102) is patterned by a lithography and etching procedure;
wherein patterning the cover layer (102) comprises forming a circumferential opening (112) through the cover layer (102) defining the position of the cavity (106), wherein in particular the cavity (106) is formed by removing, in particular by cutting out, a section of the base structure (104) within the exposed circumferential opening (112);
wherein the cavity (106) is defined by laser cutting the base structure (104) at the defined position.

4. The method according to claim 2 or 3, wherein the method further comprises attaching a temporary carrier (114) at the back side of the base structure (104) before mounting the component (110) in the cavity (106) and on the temporary carrier (114).

5. The method according to claim 4, comprising at least one of the following features:
wherein the temporary carrier (114) comprises a rigid plate;
wherein the temporary carrier (114) has a sticky surface (116) facing the base structure (104) and the component (110).

6. The method according to claims 2 to 5, wherein the method further comprises connecting the front side of the base structure (104), the cover layer (102) and the component (110) embedded in the cavity (106) with at least one electrically insulating layer structure (118) and/or at least one electrically conductive layer structure (120), in particular by laminating.

7. The method according to claims 4 and 6, wherein the method further comprises removing the temporary carrier (114) from the component (110) and the base structure (104) after the connecting.

8. The method according to claim 6 or 7, further comprising connecting at least one further electrically insulating layer structure (122) and/or at least one further electrically conductive layer structure (124) on the back side of the base structure (104) and the component (110), in particular by laminating, wherein in particular exposing the at least one alignment marker (108) comprises removing material of the at least one further electrically insulating layer structure (122) and/or at least one further electrically conductive layer structure (124).

9. The method according to claims 2 and 8, wherein forming the at least one contact (126) comprises:
forming at least one access hole through the at least one further electrically insulating layer structure (122) and/or at least one further electrically conductive layer structure (124) for exposing the embedded component (110), in particular for exposing at least one pad (130) of the embedded component (110); and
subsequently filling at least part of the at least one access hole with electrically conductive material.

10. The method according to any of claims 6 to 9, comprising at least one of the following features:
wherein the at least one electrically conductive layer structure (120) comprises at least one of the group consisting of copper, aluminum, nickel, silver, gold, palladium, and tungsten, any of the mentioned materials being optionally coated with supra-conductive material such as graphene;
wherein the at least one electrically insulating layer structure (118) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide.

11. The method according to any of claims 1 to 10, comprising at least one of the following features:
wherein the package (100) is shaped as a plate;
wherein the package (100) is configured as a component carrier, in particular is configured as one of the group consisting of a printed circuit board, and a substrate; wherein the package (100) is configured as a laminate-type package (100);
wherein the component (110) is selected from a group consisting of an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further package and a logic chip.

12. A method of manufacturing a package (100), wherein the method comprises:
patterning a cover layer (102) on a base structure (104) to thereby expose the base structure (104) selectively along a circumferential opening (112) in the cover layer (102);
forming a cavity (106) by cutting out a section of the base structure (104) within the circumferential opening (112) by cutting through the base structure (104) material which is exposed around the circumferential opening (112).

13. The method according to claim 12, comprising at least one of the following features:
wherein material of the cover layer (102) within the circumferential opening (112) remains on the base structure (104) during forming the cavity (106) ;
wherein forming the cavity (106) is carried out by laser cutting;
wherein patterning the cover layer (102) comprises forming at least one alignment marker (108) as at least one further opening in the cover layer (102) simultaneously with the forming of the circumferential opening (112);
wherein, after forming the cavity (106), sidewalls (134) of the cavity (106) are conditioned, in particular by desmearing, for subsequently embedding a component (110) therein.

14. A panel (140) for manufacturing a plurality of packages (100), wherein the panel (140) comprises:
a base structure (104) having a cavity (106);
a component (110) embedded in the cavity (106);
a patterned cover layer (102) on a front side of the base structure (104) and having at least one alignment marker (108) in form of an opening extending through the cover layer (102);
a further opening (177) extending through the base structure (104) from a back side and exposing the at least one alignment marker (108).

15. A semifinished product (150), the semifinished product (150) comprising:
a base structure (104);
a cover layer (102) on the base structure (104);
wherein the cover layer (102) is patterned so as to have a circumferential opening exposing the base structure (104) for defining a position of a cavity (106) to be formed and to have at least one further opening (112) in the cover layer (102) as at least one alignment marker (108).

## Patentansprüche

1. Ein Verfahren zum Herstellen eines Packages (100), wobei das Verfahren aufweist:
Bereitstellen einer strukturierten Abdeckschicht (102) an einer Vorderseite einer Basisstruktur (104), um dadurch eine Position von einer in der Basisstruktur (104) zu bildenden Kavität (106) und von zumindest einer Ausrichtungsmarkierung (108) in einer gemeinsamen Prozedur zu definieren;
Bilden der Kavität (106) an der definierten Position;
Entfernen von Material der Basisstruktur (104) von einer Rückseite, um dadurch die zumindest eine Ausrichtungsmarkierung (108) freizulegen.

2. Das Verfahren gemäß Anspruch 1, wobei das Verfahren aufweist
Einbetten einer Komponente (110) in der Kavität (106), so dass ein eingebettete Komponente Package (100) gebildet wird, wobei das Verfahren insbesondere aufweist
Bilden von zumindest einem Kontakt (126) zu der eingebetteten Komponente (110) von der Rückseite und an einer Position, welche von der freiliegenden zumindest einen Ausrichtungsmarkierung (108) abgeleitet ist.

3. Das Verfahren gemäß Anspruch 1 oder 2, aufweisend zumindest eines der folgenden Merkmale:
wobei die Abdeckschicht (102) eine Metallschicht ist, insbesondere eine Kupferschicht;
wobei die Abdeckschicht (102) mittels einer Lithographie- und Ätzprozedur strukturiert wird;
wobei das Strukturieren der Abdeckschicht (102) aufweist
Bilden einer Umfangsöffnung (112) durch die Abdeckschicht (102), welche die Position der Kavität (106) definiert, wobei die Kavität (106) insbesondere mittels Entfernens, insbesondere mittels Ausschneidens, eines Abschnitts der Basisstruktur (104) in der freiliegenden Umfangsöffnung (112) gebildet wird;
wobei die Kavität (106) mittels Laserschneidens der Basisstruktur (104) an der definierten Position definiert wird.

4. Das Verfahren gemäß Anspruch 2 oder 3, wobei das Verfahren ferner aufweist
Befestigen eines temporären Trägers (114) an der Rückseite der Basisstruktur (104) vor dem Montieren der Komponente (110) in der Kavität (106) und auf dem temporären Träger (114).

5. Das Verfahren gemäß Anspruch 4, aufweisend zumindest eines der folgenden Merkmale:
wobei der temporäre Träger (114) eine starre Platte aufweist;
wobei der temporäre Träger (114) eine haftfähige Oberfläche (116) hat, welche der Basisstruktur (104) und der Komponente (110) zugewandt ist.

6. Das Verfahren gemäß den Ansprüchen 2 bis 5, wobei das Verfahren ferner aufweist
Verbinden der Vorderseite der Basisstruktur (104), der Abdeckschicht (102) und der Komponente (110), welche in der Kavität (106) eingebettet ist, mit zumindest einer elektrisch isolierenden Schichtstruktur (118) und/oder zumindest einer elektrisch leitfähigen Schichtstruktur (120), insbesondere mittels Laminierens.

7. Das Verfahren gemäß den Ansprüchen 4 und 6, wobei das Verfahren ferner aufweist
Entfernen des temporären Trägers (114) von der Komponente (110) und der Basisstruktur (104) nach dem Verbinden.

8. Das Verfahren gemäß Anspruch 6 oder 7, ferner aufweisend
Verbinden von zumindest einer weiteren elektrisch isolierenden Schichtstruktur (122) und/oder von zumindest einer weiteren elektrisch leitfähigen Schichtstruktur (124) mit der Rückseite der Basisstruktur (104) und der Komponente (110), insbesondere mittels Laminierens, wobei insbesondere das Freilegen der zumindest einen Ausrichtungsmarkierung (108) aufweist
Entfernen von Material der zumindest einen weiteren elektrisch isolierenden Schichtstruktur (122) und/oder der zumindest einen weiteren elektrisch leitfähigen Schichtstruktur (124).

9. Das Verfahren gemäß den Ansprüchen 2 und 8, wobei das Bilden des zumindest einen Kontakts (126) aufweist:
Bilden von zumindest einer Zugangsöffnung durch die zumindest eine weitere elektrisch isolierende Schichtstruktur (122) und/oder die zumindest eine weitere elektrisch leitfähige Schichtstruktur (124) zum Freilegen der eingebetteten Komponente (110), insbesondere zum Freilegen von zumindest einem Pad (130) der eingebetteten Komponente (110); und
nachfolgendes Füllen von zumindest einem Teil der zumindest einen Zugangsöffnung mit einem elektrisch leitfähigen Material.

10. Das Verfahren gemäß irgendeinem der Ansprüche 6 bis 9, aufweisend zumindest eines der folgenden Merkmale:
wobei die zumindest eine elektrisch leitfähige Schichtstruktur (120) zumindest eines aus der Gruppe aufweist, bestehend aus Kupfer, Aluminium, Nickel, Silber, Gold, Palladium und Wolfram, wobei jedes der genannten Materialien optional mit einem supra-leitfähigen Material beschichtet ist, beispielsweise Graphen;
wobei die zumindest eine elektrisch isolierende Schichtstruktur (118) zumindest eines aus der Gruppe aufweist, bestehend aus Harz, insbesondere verstärktem oder nicht-verstärktem Harz, beispielsweise Epoxidharz oder Bismaleimid-Triazin Harz, FR-4, FR-5, Cyanatester, Polyphenylen Derivat, Glas, Prepreg Material, Polyimid, Polyamid, flüssigkristallinem Polymer, Epoxidbasierter Aufbaufolie, Polytetrafluorethylen, einer Keramik und einem Metalloxid.

11. Das Verfahren gemäß irgendeinem der Ansprüche 1 bis 10, aufweisend zumindest eines der folgenden Merkmale:
wobei das Package (100) plattenförmig ist;
wobei das Package (100) als ein Komponententräger konfiguriert ist, insbesondere als eines aus der Gruppe konfiguriert ist, bestehend aus einer gedruckten Leiterplatte und einem Substrat;
wobei das Package (100) als ein Laminat-artiges Package (100) konfiguriert ist;
wobei die Komponente (110) aus einer Gruppe ausgewählt ist, bestehend aus einer elektronischen Komponente, einem elektrisch nicht-leitfähigen und/oder elektrisch leitfähigen Inlay, einer Wärmeübertragungseinheit, einem lichtleitenden Element, einer Energy Harvesting Einheit, einer aktiven elektronischen Komponente, einer passiven elektronischen Komponente, einem elektronischen Chip, einer Speichervorrichtung, einem Filter, einem integrierten Schaltkreis, einer Signalverarbeitungskomponente, einer Leistungsmanagement Komponente, einem optoelektronischen Schnittstellenelement, einem Spannungswandler, einer kryptographischen Komponente, einem Sender und/oder Empfänger, einem elektromechanischen Transducer, einem Aktuator, einem mikroelektromechanischen System, einem Mikroprozessor, einem Kondensator, einem Widerstand, einer Induktanz, einem Akkumulator, einem Schalter, einer Kamera, einer Antenne, einem magnetischen Element, einem weiteren Package und einem Logikchip.

12. Ein Verfahren zum Herstellen eines Packages (100), wobei das Verfahren aufweist:
Strukturieren einer Abdeckschicht (102) auf einer Basisstruktur (104), um dadurch die Basisstruktur (104) selektiv entlang einer Umfangsöffnung (112) in der Abdeckschicht (102) freizulegen;
Bilden einer Kavität (106) mittels Ausschneidens eines Abschnitts der Basisstruktur (104) in der Umfangsöffnung (112) mittels Schneidens durch das Basisstruktur (104) Material, welches um die Umfangsöffnung (112) freiliegt.

13. Das Verfahren gemäß Anspruch 12, aufweisend zumindest eines der folgenden Merkmale:
wobei das Material der Abdeckschicht (102) in der Umfangsöffnung (112) während des Bildens der Kavität (106) auf der Basisstruktur (104) bleibt;
wobei das Bilden der Kavität (106) mittels Laserschneidens ausgeführt wird;
wobei das Strukturieren der Abdeckschicht (102) aufweist
Bilden von zumindest einer Ausrichtungsmarkierung (108) als zumindest eine weitere Öffnung in der Abdeckschicht (102) gleichzeitig mit dem Bilden der Umfangsöffnung (112);
wobei, nach dem Bilden der Kavität (106), Seitenwände (134) der Kavität (106) konditioniert werden, insbesondere mittels Rückätzens, für ein nachfolgendes Einbetten einer Komponente (110) darin.

14. Ein Panel (140) zum Herstellen einer Mehrzahl von Packages (100), wobei das Panel (140) aufweist:
eine Basisstruktur (104), welche eine Kavität (106) hat;
eine Komponente (110), welche in der Kavität (106) eingebettet ist;
eine strukturierte Abdeckschicht (102) an einer Vorderseite der Basisstruktur (104) und welche zumindest eine Ausrichtungsmarkierung (108) in Form einer Öffnung hat, welche sich durch die Abdeckschicht (102) erstreckt;
eine weitere Öffnung (177), welche sich von einer Rückseite durch die Basisstruktur (104) erstreckt und die zumindest eine Ausrichtungsmarkierung (108) freilegt.

15. Ein Zwischenprodukt (150), wobei das Zwischenprodukt (150) aufweist:
eine Basisstruktur (104);
eine Abdeckschicht (102) auf der Basisstruktur (104);
wobei die Abdeckschicht (102) so strukturiert ist, dass sie
eine Umfangsöffnung hat, welche die Basisstruktur (104) zum Definieren einer Position einer zu bildenden Kavität (106) freilegt, und
zumindest eine weitere Öffnung (112) in der Abdeckschicht (102) als zumindest eine Ausrichtungsmarkierung (108) hat.

## Revendications

1. Un procédé de fabrication d'un boîtier (100), le procédé comprenant :
le fait de prévoir une couche de recouvrement (102) à motifs sur une face avant d'une structure de base (104) pour définir ainsi, par une procédure commune, une position d'une cavité (106) destinée à être formée dans la structure de base (104) et d'au moins un repère d'alignement (108) ;
le fait de former la cavité (106) à la position définie ;
le fait d'enlever le matériau de la structure de base (104) à partir d'un côté arrière pour ainsi exposer ledit au moins un marqueur d'alignement (108).

2. Le procédé selon la revendication 1, dans lequel le procédé comprend le fait d'encastrer un composant (110) dans la cavité (106) de manière à former un boîtier (100) à composant encastré, le procédé comprenant notamment le fait de former au moins un contact (126) avec le composant encastré (110) depuis le côté arrière et en une position dérivée dudit au moins un marqueur d'alignement (108) exposé.

3. Le procédé selon la revendication 1 ou la revendication 2, comprenant au moins l'une des caractéristiques suivantes :
la couche de recouvrement (102) est une couche métallique, en particulier une couche de cuivre ;
la couche de recouvrement (102) fait l'objet de l'aménagement d'un motif par une procédure de lithographie et de gravure ;
l'aménagement du motif de la couche de recouvrement (102) comprend le fait de former une ouverture circonférentielle (112) à travers la couche de recouvrement (102) définissant la position de la cavité (106), la cavité (106) étant notamment formée par enlèvement, notamment par découpe, d'une portion de la structure de base (104) à l'intérieur de l'ouverture circonférentielle (112) exposée ;
la cavité (106) est définie par découpe au laser de la structure de base (104) à la position définie.

4. Le procédé selon la revendication 2 ou la revendication 3, dans lequel le procédé comprend en outre le fait de fixer un support temporaire (114) sur le côté arrière de la structure de base (104) avant de monter le composant (110) dans la cavité (106) et sur le support temporaire (114).

5. Le procédé selon la revendication 4, comprenant au moins l'une des caractéristiques suivantes :
le support temporaire (114) comprend une plaque rigide ;
le support temporaire (114) a une surface collante (116) tournée vers la structure de base (104) et le composant (110).

6. Le procédé selon les revendications 2 à 5, dans lequel le procédé comprend en outre le fait de relier le côté avant de la structure de base (104), la couche de recouvrement (102) et le composant (110) encastré dans la cavité (106) avec au moins une structure de couche électriquement isolante (118) et / ou au moins une structure de couche électriquement conductrice (120), notamment par stratification.

7. Le procédé selon les revendications 4 et 6, dans lequel le procédé comprend en outre le fait de retirer le support temporaire (114) du composant (110) et de la structure de base (104) après la connexion.

8. Le procédé selon la revendication 6 ou la revendication 7, comprenant en outre le fait de connecter au moins une autre structure de couche électriquement isolante (122) et / ou au moins une autre structure de couche électriquement conductrice (124) sur le côté arrière de la structure de base (104) et du composant (110), notamment par stratification, l'exposition dudit au moins un marqueur d'alignement (108) comprenant en particulier le fait de retirer de la matière de ladite au moins une autre structure de couche électriquement isolante (122) et / ou de ladite au moins une autre structure de couche électriquement conductrice (124).

9. Le procédé selon les revendications 2 et 8, dans lequel la formation dudit au moins un contact (126) comprend :
le fait de former au moins un trou d'accès à travers ladite au moins une autre structure de couche électriquement isolante (122) et / ou ladite au moins une autre structure de couche électriquement conductrice (124) de façon à exposer le composant encastré (110), en particulier pour exposer au moins une pastille (130) du composant encastré (110) ; et
le fait de remplir ultérieurement au moins une partie dudit au moins un trou d'accès avec un matériau électriquement conducteur.

10. Le procédé selon l'une quelconque des revendications 6 à 9, comprenant au moins l'une des caractéristiques suivantes :
ladite au moins une structure de couche électriquement conductrice (120) comprend au moins un membre du groupe consistant en le cuivre, l'aluminium, le nickel, l'argent, l'or, le palladium et le tungstène, l'un quelconque des matériaux mentionnés étant optionnellement revêtu d'un matériau supraconducteur tel que le graphène ;
ladite au moins une structure de couche électriquement isolante (118) comprend au moins un membre du groupe constitué par de la résine, en particulier une résine renforcée ou non renforcée, par exemple une résine époxy ou une résine bismaléimide-triazine, du FR-4, du FR-5, un cyanate ester, un dérivé de polyphénylène, du verre, un matériau préimprégné, du polyimide, du polyamide, un polymère à cristaux liquides, un film de constitution à base d'époxy, un polytétrafluoroéthylène, une céramique et un oxyde métallique.

11. Le procédé selon l'une quelconque des revendications 1 à 10, comprenant au moins l'une des caractéristiques suivantes :
le boîtier (100) a la forme d'une plaque ;
le boîtier (100) est configuré comme un support de composant, en particulier est configuré comme un membre du groupe constitué par une carte à circuit imprimé et un substrat ; le boîtier (100) étant configuré comme un boîtier de type stratifié (100) ;
le composant (110) est choisi dans un groupe comprenant un composant électronique, un inlay électriquement non conducteur et / ou électriquement conducteur, une unité de transfert de chaleur, un élément de guidage de lumière, une unité de récupération d'énergie, un composant électronique actif, un composant électronique passif, une puce électronique, un dispositif de stockage, un filtre, un circuit intégré, un composant de traitement du signal, un composant de gestion de puissance, un élément d'interface optoélectronique, un convertisseur de tension, un composant cryptographique, un émetteur et / ou un récepteur, un transducteur électromécanique, un actionneur, un système microélectromécanique, un microprocesseur, un condensateur, une résistance, une inductance, un accumulateur, un interrupteur, un appareil de prise de vues, une antenne, un élément magnétique, un autre boîtier et une puce logique.

12. Un procédé de fabrication d'un boîtier (100), le procédé comprenant :
le fait d'aménager un motif dans une couche de recouvrement (102) sur une structure de base (104) pour exposer ainsi la structure de base (104) sélectivement le long d'une ouverture circonférentielle (112) dans la couche de recouvrement (102) ;
le fait de former une cavité (106) en découpant une portion de la structure de base (104) à l'intérieur de l'ouverture circonférentielle (112) en découpant à travers la structure de base (104) un matériau qui est exposé autour de l'ouverture circonférentielle (112).

13. Le procédé selon la revendication 12, comprenant au moins l'une des caractéristiques suivantes :
le matériau de la couche de recouvrement (102) à l'intérieur de l'ouverture circonférentielle (112) reste sur la structure de base (104) pendant la formation de la cavité (106) ;
la formation de la cavité (106) est réalisée par découpe au laser ;
la formation de motifs sur la couche de recouvrement (102) comprend la formation d'au moins un marqueur d'alignement (108) en tant qu'au moins une autre ouverture dans la couche de recouvrement (102) simultanément à la formation de l'ouverture circonférentielle (112) ;
après la formation de la cavité (106), les parois latérales (134) de la cavité (106) sont mises en condition, notamment par déglaçage, pour encastrer ultérieurement un composant (110) dans celle-ci.

14. Un panneau (140) pour fabriquer une pluralité de boîtiers (100), dans lequel le panneau (140) comprend :
une structure de base (104) ayant une cavité (106) ;
un composant (110) encastré dans la cavité (106) ;
une couche de couverture à motifs (102) sur un côté avant de la structure de base (104) et ayant au moins un marqueur d'alignement (108) sous la forme d'une ouverture s'étendant à travers la couche de recouvrement (102) ;
une autre ouverture (177) s'étendant à travers la structure de base (104) depuis un côté arrière et exposant ledit au moins un marqueur d'alignement (108).

15. Un produit semi-fini (150), le produit semi-fini (150) comprenant :
une structure de base (104) ;
une couche de recouvrement (102) sur la structure de base (104) ;
la couche de recouvrement (102) étant aménagée de manière à avoir une ouverture circonférentielle exposant la structure de base (104) pour définir une position d'une cavité (106) destinée à être formée et pour avoir au moins une autre ouverture (112) dans la couche de recouvrement (102) en tant qu'au moins un marqueur d'alignement (108).
